# EUROPEAN PATENT APPLICATION

(11) **EP 2 890 013 A1**
(43) Date of publication of application: **01.07.2015**
(21) Application number: 14275089.2
(22) Date of filing: 23.04.2014
(51) Int. Cl.: H03L 7/099, H03L 7/197

(54) **Phase locked loop and control method thereof**

(30) Priority: 27.12.2013 KR 20130165451
(71) Applicant: Samsung Electro-Mechanics Co., Ltd., Gyeonggi-do (KR)
(72) Inventor: Kim,, Myeung Su, Gyeonggi-Do (KR)
(74) Representative: Potter Clarkson LLP

(57) **Abstract**

A phase locked loop may include: a phase detector receiving a reference signal from the outside and detecting a phase difference between the reference signal and a divided signal, a voltage controlled oscillator generating an oscillation signal corresponding to a result detected by the phase detector, a first divider providing the divided signal generated by dividing the oscillation signal depending on a first division ratio to the phase detector, and a delta sigma modulator receiving the reference signal and the oscillation signal to perform delta sigma modulation. The delta sigma modulator may be operated depending on a clock corresponding to a frequency of the oscillation signal in a first section and operated depending on a clock corresponding to a frequency of the reference signal in a second section.

## Description

### CROSS-REFERENCE TO RELATED APPLICATION

This application claims the benefit of Korean Patent Application No. 10-2013-0165451 filed on December 27, 2013, with the Korean Intellectual Property Office, the disclosure of which is incorporated herein by reference.

### BACKGROUND

The present disclosure relates to a phase locked loop and a control method thereof.

As the minimum line width of patterns of semiconductor devices has been reduced to several tens of nm or less with technological developments in the field of semiconductors, and thus, semiconductor chip competitiveness has tended to rely on a chip area. Therefore, structures allowing for reductions in chip areas have been variously developed, even in the area of the telecommunications chip market. Among them, a structure of a phase locked loop (PLL) modulator which may remove a mixer and a DAC of a transmitting terminal has recently been developed.

In the case of a phase locked loop transmitting data to an input of a divider and a voltage controlled oscillator (VCO), data is transmitted along two paths and thus high and low characteristics thereof are complementarily compensated, such that signal distortion may be reduced. The phase locked loop controls a gain of the voltage controlled oscillator (VCO) so as to compensate for a gain mismatch between the two paths.

However, even though the phase locked loop compensates for the gain input to the voltage controlled oscillator (VCO), a frequency offset inevitably occurs due to a signal passing through the divider. The reason for this is that it is difficult to accurately move a desired frequency for a rapid data section due to a limited reaction time of a delta sigma modulator in the case of using such a delta sigma modulator.

The following Related Art Document relates to a frequency generator and a clock generator and discloses contents to reduce an electro magnetic interface (EMI) which occurs due to an oscillation frequency. However, unlike the present disclosure, the following Related Art Document does not disclose reducing the reaction time of the delta sigma modulator by making an operating frequency different in each preset section.

### [Related Art Document]

Korean Patent Laid-Open Publication No. 10-2012-0047379

### SUMMARY

Some embodiments of the present disclosure may provide a phase locked loop and a control method thereof capable of reducing a reaction time by varying an operating frequency of a delta sigma modulator in each preset section.

According to some embodiments of the present disclosure, a phase locked loop may include: a phase detector receiving a reference signal from the outside and detecting a phase difference between the reference signal and a divided signal; a voltage controlled oscillator generating an oscillation signal corresponding to a result detected by the phase detector; a first divider providing the divided signal generated by dividing the oscillation signal depending on a first division ratio to the phase detector; and a delta sigma modulator receiving the reference signal and the oscillation signal to perform delta sigma modulation, in which the delta sigma modulator may be operated depending on a clock corresponding to a frequency of the oscillation signal in a first section and may be operated depending on a clock corresponding to a frequency of the reference signal in a second section.

The delta sigma modulator may perform delta sigma modulation on the oscillation signal and provide the modulated oscillation signal to the first divider to control the first division ratio.

The delta sigma modulator may be converted from the first section to the second section when a preset time elapses.

A frequency value of the oscillation signal may be higher than that of the reference signal.

The phase locked loop may further include: a charge pump generating a charge or a current corresponding to an output signal from the phase detector; and a loop filter outputting a predetermined voltage corresponding to an amount of a charge charged or discharged depending on an output from the charge pump and providing the predetermined output voltage to the voltage controlled oscillator.

The phase locked loop may further include: a second divider receiving the oscillation signal from the voltage controlled oscillator, dividing the received oscillation signal depending on a second division ratio, and providing the divided oscillation signal to the first divider and the delta sigma modulator.

According to some embodiments of the present disclosure, a control method of a phase locked loop may include: receiving, by a phase detector and a delta sigma modulator, a reference signal; detecting, with the phase detector, a phase difference between the reference signal and a divided signal; generating, with a voltage controlled oscillator, an oscillation signal corresponding to a result of the phase difference and providing the generated oscillation signal to a first divider and the delta sigma modulator; dividing, with the first divider, the oscillation signal depending on the first division ratio to generate the divided signal and provide the generated divided signal to the phase detector and the delta sigma modulator; performing, with the delta sigma modulator, a first sigma modulation depending on a clock corresponding to a frequency of the oscillation signal for a first section; and performing, with the delta sigma modulator, a second sigma modulation depending on a clock corresponding to a frequency of the reference signal for a second section.

In the performing of the second sigma modulation, the second sigma modulation may be performed on the oscillation signal depending on the clock corresponding to the frequency of the reference signal for the second section so as to control the first division ratio.

A frequency value of the oscillation signal may be higher than that of the reference signal.

The control method of a phase locked loop may further include: generating, with a charge pump, a charge or a current corresponding to an output signal from the phase detector; and outputting, by a loop filter, a predetermined voltage corresponding to an amount of a charge charged or discharged depending on an output from the charge pump and providing the predetermined output voltage to the voltage controlled oscillator.

The control method of a phase locked loop may further include: receiving, by a second divider, the oscillation signal from the voltage controlled oscillator, dividing the received oscillation signal depending on a second division ratio, and providing the divided oscillation signal to the first divider and the delta sigma modulator.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a block diagram illustrating a phase locked loop according to an exemplary embodiment of the present disclosure;
FIG. 2 is a block diagram illustrating the phase locked loop illustrated in FIG. 1 in more detail;
FIG. 3 is a graph illustrating a reaction time of an output from a delta sigma modulator of a phase locked loop according to the related art;
FIG. 4 is a diagram illustrating a frequency offset in the delta sigma modulator of the phase locked loop according to the related art;
FIG. 5 is a graph for describing an operation of a delta sigma modulator of a phase locked loop according to an exemplary embodiment of the present disclosure;
FIG. 6 is graph illustrating an output waveform of the delta sigma modulator of the phase locked loop according to the related art;
FIG. 7A is a graph illustrating an output waveform of the delta sigma modulator of the phase locked loop according to an exemplary embodiment of the present disclosure;
FIG. 7B is a graph illustrating an output waveform of the delta sigma modulator in an ideal case;
FIG. 8 is a flow chart illustrating a control method of a phase locked loop according to another embodiment of the present disclosure; and
FIG. 9 is a flow chart illustrating in more detail the control method of the phase locked loop illustrated in FIG. 8.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. In the drawings, the shapes and dimensions of elements may be exaggerated for clarity, and the same reference numerals will be used throughout to designate the same or like elements.

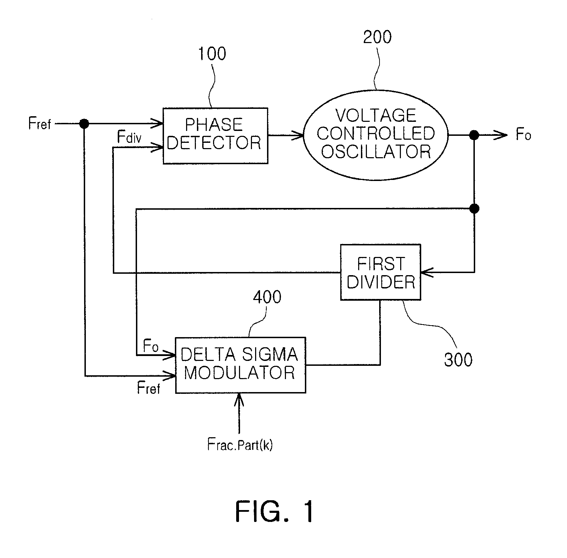

FIG. 1 is a block diagram illustrating a phase locked loop according to an exemplary embodiment of the present disclosure.

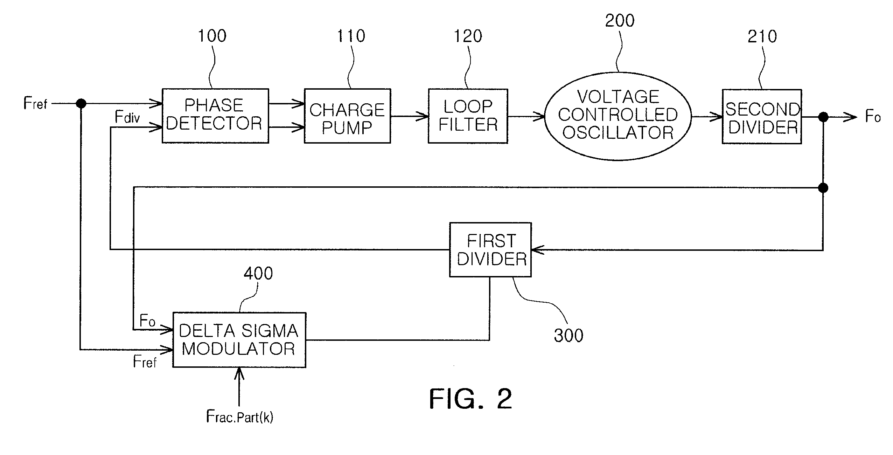

FIG. 2 is a block diagram illustrating the phase locked loop illustrated in FIG. 1 in more detail.

Referring to FIGS. 1 and 2, the phase locked loop according to the exemplary embodiment of the present disclosure may include a phase detector 100, a voltage controlled oscillator 200, a first divider 300, and a delta sigma modulator 400.

Further, the phase locked loop may further include a charge pump 110, a loop filter 120, and a second divider 210.

The phase detector 100 may receive a reference signal Fref from the outside and detect a phase difference between the reference signal Fref and a divided signal Fdiv. In this case, the reference signal Fref may be received from an external crystal oscillator. Further, a frequency value of the reference signal Fref may be, for example, 32 MHz. Further, the divided signal Fdiv may be received from the first divider 300.

For example, the phase detector 100 may detect the phase difference between the reference signal Fref and the divided signal Fdiv and may provide an output signal based on the detected result to the charge pump 110. In this case, the phase detector 100 may provide an up signal or a down signal to the charge pump 110.

The charge pump 110 may generate a charge or a current corresponding to the output signal from the phase detector 100. For example, when the charge pump 110 receives the up signal from the phase detector 100, the charge pump 100 may provide a current to the loop filter 120.

On the other hand, when the charge pump receives the down signal from the phase detector 100, the charge pump 110 may absorb a current.

The loop filter 120 may output a predetermined voltage corresponding to an amount of a charge charged or discharged depending on the output from the charge pump 110. In this case, the loop filter 120 may provide the predetermined output voltage to the voltage controlled oscillator 200. An example of the loop filter 120 may include a capacitor. For example, the loop filter 120 may output the predetermined voltage corresponding to the charge amount charged or discharged in the capacitor depending on the output from the charge pump 110. For example, the loop filter 120 may generate a higher voltage when a current is supplied from the charge pump 110 than when the charge pump 110 absorbs a current.

Meanwhile, an example of the loop filter 120 may be a low pass filter which filters a high frequency component of the output from the charge pump 110.

The voltage controlled oscillator 200 may generate an oscillation signal Fo corresponding to the result detected by the phase detector 100. In more detail, the voltage control led oscillator 200 may generate the oscillation signal Fo corresponding to the predetermined output voltage, generated by the loop filter 120. In this case, a frequency band of the oscillation signal Fo output from the voltage controlled oscillator 200 may be higher than that of the reference signal Fref.

The first divider 300 may divide the oscillation signal Fo depending on a first division ratio and may generate the divided signal Fdiv. Next, the first divider 300 may provide the divided signal Fdiv to the phase detector 100. In this case, the first division ratio may be preset, but the first division ratio may be controlled depending on the output from the delta sigma modulator 400.

The delta sigma modulator 400 receives the reference signal Fref and the oscillation signal Fo to perform delta sigma modulation. In this case, the delta sigma modulator 400 may be operated depending on a clock corresponding to the frequency of the oscillation signal Fo in a first section and operated depending on a clock corresponding to the frequency of the reference signal Fref in a second section. For example, the delta sigma modulator 400 may be operated by a dual clock.

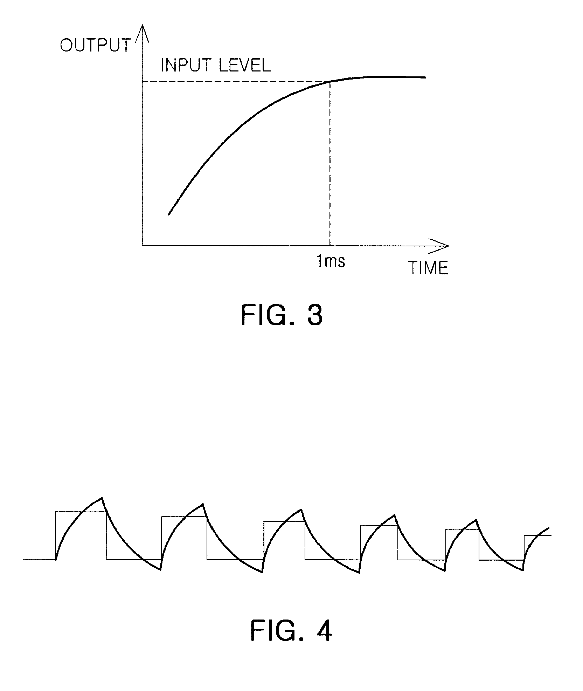

This will be described in more detail with reference to FIGS. 3 to 7.

Meanwhile, the phase locked loop according to the exemplary embodiment of the present disclosure may further include a second divider 210 which receives the oscillation signal from the voltage controlled oscillator 200 and divides the received oscillation signal depending on a preset second division ratio. The second divider 210 may provide the signal divided depending on the second division ratio to the first divider 300 and the delta sigma modulator 400, respectively.

The first divider 300 may receive the signal, divide the received signal depending on the first division ratio, and provide the divided signal to the phase detector 100. Further, the delta sigma modulator 400 may receive, as an input, a signal obtained by dividing the oscillation signal depending on the second division ratio.

FIG. 3 is graph illustrating a reaction time of an output from a delta sigma modulator of a phase locked loop according to the related art.

FIG. 4 is a diagram illustrating a frequency offset in the delta sigma modulator of the phase locked loop according to the related art.

Referring to FIG. 3, when the phase locked loop according to the related art is operated using a single clock (frequency of the reference signal), it may be appreciated that a reaction time of an output signal to an input level is significantly long. The characteristics are not substantially a problem in the frequency generator which generates a carrier signal, but may be a cause of a frequency offset in the modulator.

Referring to FIG. 4, the phase locked loop according to the related art uses the single clock (frequency of the reference signal) and thus causes the reaction time of the output from the delta sigma modulator longer than a period of a data signal, such that a difference between the output and the input appears. Thus, to reduce the reaction time, a rapid frequency may be used but the frequency of the reference signal is set in a system, such that a freedom of selection may be reduced.

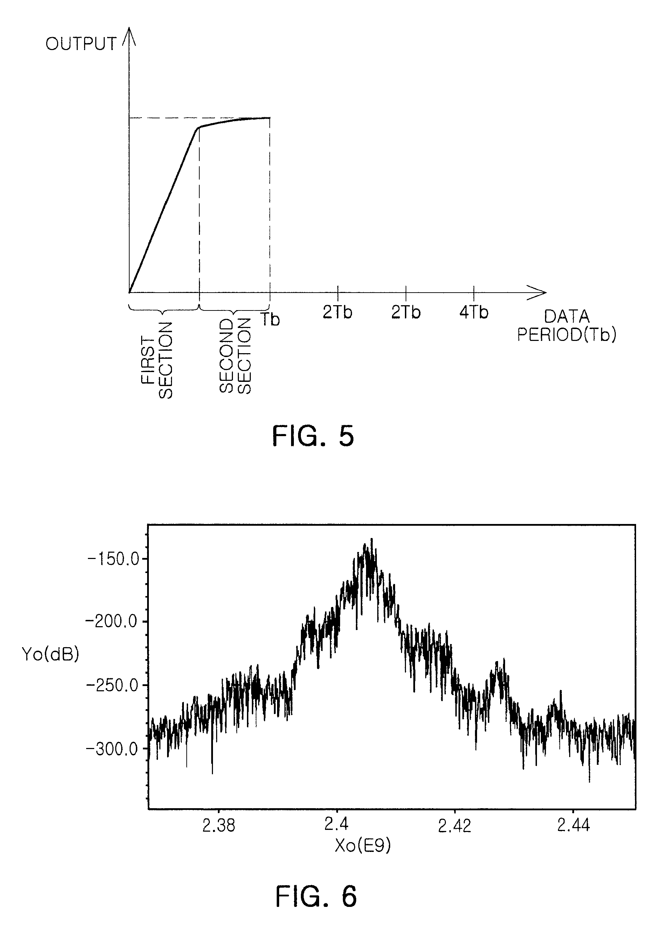

FIG. 5 is a graph for describing an operation of the delta sigma modulator 400 of the phase locked loop according to an exemplary embodiment of the present disclosure.

Referring to FIG. 5, the delta sigma modulator 400 among configurations of the phase locked loop according to the exemplary embodiment of the present disclosure may be operated depending on the clock corresponding to the frequency of the oscillation signal Fo in the first section and operated depending on the clock corresponding to the frequency of the reference signal Fref in the second section.

In this case, the frequency band of the oscillation signal Fo may be, for example, 150 MHz, a fast frequency band and the frequency band of the reference signal Fref may be, for example, 32 MHz, a frequency band lower than that of the oscillation signal Fo.

When the delta sigma modulator 400 is first operated at 150 MHz in the first section at a differential time, the delta sigma modulator 400 is rapidly operated and thus the output value thereof may be converged to a desired approximation value and when a preset time elapses or the output value of the delta sigma modulator 400 is converged to the desired value, the delta sigma modulator 400 may be operated at 32 MHz in the second section.

However, the output value of the delta sigma modulator 400 is not transferred to the first divider 300 in the first section and the output value of the delta sigma modulator 400 is transferred to the first divider 300 from the second section and thus the first division ratio may be controlled depending on the output value of the delta sigma modulator 400.

FIG. 6 is graph illustrating an output waveform of the delta sigma modulator 400 of the phase locked loop according to the related art.

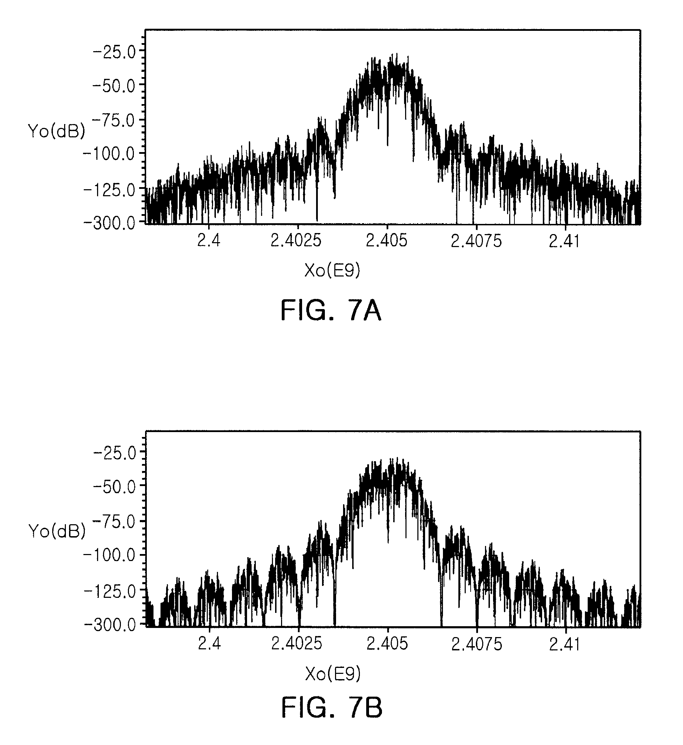

FIG. 7 is a comparison graph of the output waveform of the delta sigma modulator 400 of the phase locked loop according to the exemplary embodiment of the present disclosure with an output waveform of the delta sigma modulator in an ideal case.

Since the phase locked loop according to the related art is operated by the single clock corresponding to the frequency band of the reference signal Fref, as illustrated in FIGS. 3 and 4, there is a problem in that the reaction time of the output from the delta sigma modulator 400 with respect to the input is relatively, very long. Therefore, the frequency offset of the delta sigma modulator 400 may occur.

FIG. 7A is a graph illustrating the output waveform of the delta sigma modulator 400 of the phase locked loop according to the exemplary embodiment of the present disclosure.

FIG. 7B is a graph illustrating an output waveform of the delta sigma modulator in an ideal case.

In this case, it may be appreciated that the output waveform of the delta sigma modulator 400 illustrated in FIG. 7A substantially matches the ideal output waveform of the delta sigma modulator illustrated in FIG. 7B.

For example, the delta sigma modulator 400 according to the exemplary embodiment of the present disclosure is operated depending on the dual clock, such that the reaction time of the output is relatively short and the difference between the output and the input does not substantially appear. On the other hand, referring to FIG. 6, it may be appreciated that the phase locked loop according to the related art is different from the graph illustrated in FIG. 7B.

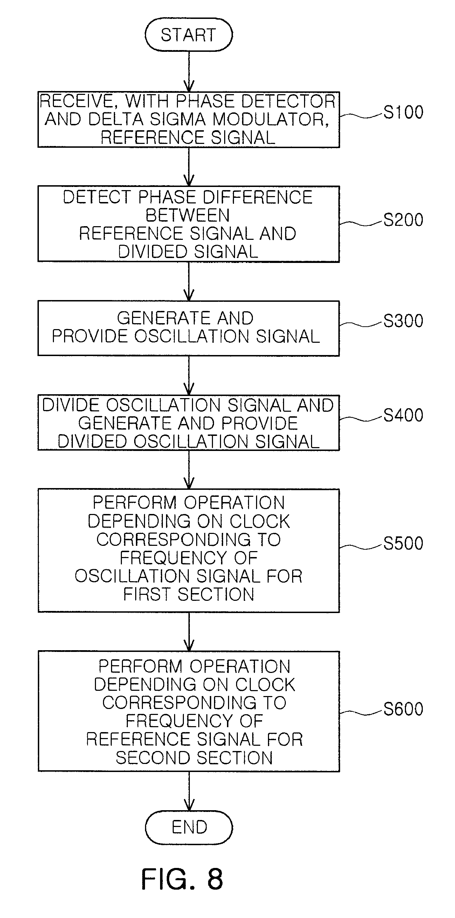

FIG. 8 is a flow chart illustrating a control method of a phase locked loop according to another embodiment of the present disclosure.

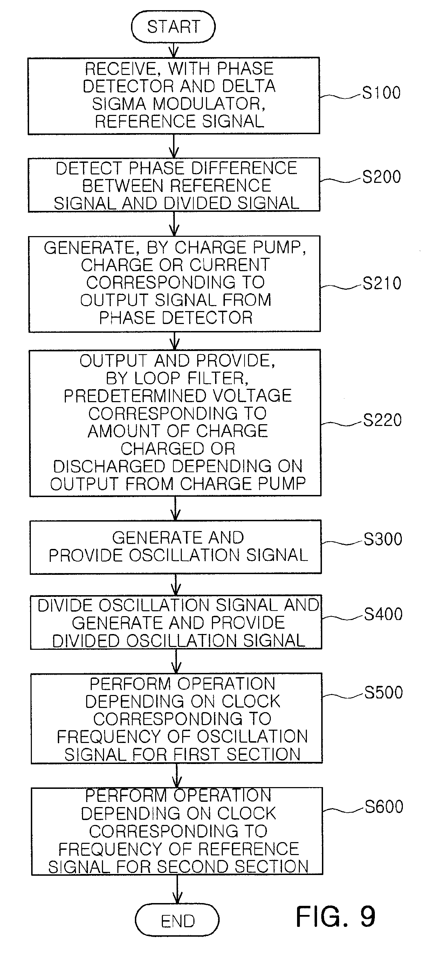

FIG. 9 is a flow chart illustrating in more detail the control method of the phase locked loop illustrated in FIG. 8.

Referring to FIGS. 8 and 9, the control method of the phase locked loop according to the exemplary embodiment of the present disclosure may include: receiving, with the phase detector 100 and the delta sigma modulator 400, the reference signal Fref (S100); detecting, with the phase detector 100, the phase difference between the reference signal Fref and the divided signal Fdiv (S200); generating the oscillation signal Fo corresponding to the result of the phase difference and providing the generated oscillation signal Fo to the first divider 300 and the delta sigma modulator 400, with the voltage controlled oscillator 200 (S300); dividing, with the first divider 300, the oscillation signal Fo depending on the first division ratio to generate the divided signal Fdiv and provide the generated divided signal Fdiv to the phase detector 100 and the delta sigma modulator 400 (S400) ; performing, with the delta sigma modulator 400, a first sigma modulation depending on the clock corresponding to the frequency of the oscillation signal Fo for the first section (S500) ; and performing, with the delta sigma modulator 400, a second sigma modulation depending on the clock corresponding to the frequency of the reference signal Fref for the second section (S600).

Further, generating, with the charge pump 110, a charge or a current corresponding to the output signal from the phase detector 100 (S210), and outputting the predetermined voltage corresponding to the charge amount, charged or discharged depending on the output from the charge pump 110, and providing the predetermined output voltage to the voltage controlled oscillator 200, by the loop filter 120, (S220) may be included between the detecting of the phase difference (S200) and the generating and providing of the oscillation signal Fo (S300).

According to exemplary embodiments of the present disclosure, the phase locked loop and the control method thereof may reduce the reaction time by allowing the operating frequency of the delta sigma modulator to be different in each preset section, to thereby converging the output value of the delta sigma modulator to the desired value.

While exemplary embodiments have been shown and described above, it will be apparent to those skilled in the art that modifications and variations could be made without departing from the spirit and scope of the present disclosure as defined by the appended claims.

## Claims

1. A phase locked loop, comprising:
a phase detector receiving a reference signal from an outside and detecting a phase difference between the reference signal and a divided signal;
a voltage controlled oscillator generating an oscillation signal corresponding to a result detected by the phase detector;
a first divider providing the divided signal generated by dividing the oscillation signal depending on a first division ratio to the phase detector; and
a delta sigma modulator receiving the reference signal and the oscillation signal to perform delta sigma modulation,
wherein the delta sigma modulator is operated depending on a clock corresponding to a frequency of the oscillation signal in a first section and operated depending on a clock corresponding to a frequency of the reference signal in a second section.

2. The phase locked loop of claim 1, wherein the delta sigma modulator performs delta sigma modulation on the oscillation signal and provides the modulated oscillation signal to the first divider to control the first division ratio.

3. The phase locked loop of claim 1, wherein the delta sigma modulator is converted from the first section to the second section when a preset time elapses.

4. The phase locked loop of claim 1, wherein a frequency value of the oscillation signal is higher than that of the reference signal.

5. The phase locked loop of claim 1, further comprising:
a charge pump generating a charge or a current corresponding to an output signal from the phase detector; and
a loop filter outputting a predetermined voltage corresponding to an amount of a charge which is charged or discharged depending on an output from the charge pump and providing the predetermined output voltage to the voltage controlled oscillator.

6. The phase locked loop of claim 1, further comprising a second divider receiving the oscillation signal from the voltage controlled oscillator, dividing the received oscillation signal depending on a second division ratio, and providing the divided oscillation signal to the first divider and the delta sigma modulator.

7. A control method of a phase locked loop, comprising:
receiving, by a phase detector and a delta sigma modulator, a reference signal;
detecting, with the phase detector, a phase difference between the reference signal and a divided signal;
generating, with a voltage controlled oscillator, an oscillation signal corresponding to a result of the phase difference and providing the generated oscillation signal to a first divider and the delta sigma modulator;
dividing, with the first divider, the oscillation signal depending on the first division ratio to generate the divided signal and provide the generated divided signal to the phase detector and the delta sigma modulator;
performing, with the delta sigma modulator, a first sigma modulation depending on a clock corresponding to a frequency of the oscillation signal for a first section; and
performing, with the delta sigma modulator, a second sigma modulation depending on a clock corresponding to a frequency of the reference signal for a second section.

8. The control method of claim 7, wherein in the performing of the second sigma modulation, the second sigma modulation is performed on the oscillation signal depending on the clock corresponding to the frequency of the reference signal for the second section so as to control the first division ratio.

9. The control method of claim 7, wherein a frequency value of the oscillation signal is higher than that of the reference signal.

10. The control method of claim 7, further comprising:
generating, with a charge pump, a charge or a current corresponding to an output signal from the phase detector; and
outputting, by a loop filter, a predetermined voltage corresponding to an amount of a charge charged or discharged depending on an output from the charge pump and providing the predetermined output voltage to the voltage controlled oscillator.

11. The control method of claim 7, further comprising:
receiving, by a second divider, the oscillation signal from the voltage controlled oscillator, dividing the received oscillation signal depending on a second division ratio, and providing the divided oscillation signal to the first divider and the delta sigma modulator.
